# EUROPÄISCHE PATENTSCHRIFT

(11) **EP 0 819 946 B1**
(45) Veröffentlichungstag und Bekanntmachung des Hinweises auf die Patenterteilung: **18.12.2002**
(21) Anmeldenummer: 97109802.5
(22) Anmeldetag: 17.06.1997
(51) Int. Cl.: G01R 29/26, G01R 29/08

(54) **Anordnung zum Erkennen einer Störstrahlung**
Appliance for detecting radio interference
Dispositif pour détecter une radiation disturbatrice

(30) Priorität: 18.07.1996 DE 19628918
(43) Veröffentlichungstag der Anmeldung: 21.01.1998
(73) Patentinhaber: Airbus Deutschland GmbH, 21129 Hamburg (DE)
(72) Erfinder: Weiler, Werner, Ing. grad., 31358 Colomiers (FR); Krumbholz, Michael, Dipl.-Ing., 25358 Horst (DE); Hildebrandt, Fred, Dipl.-Ing., 21244 Buchholz (DE)
(74) Vertreter: Hansmann, Dierk, Dipl.-Ing.

(56) Entgegenhaltungen:
- GB-A- 2 168 880
- US-A- 5 543 779
- HELFRICK: "Interference to digital avionics due to electromagnetic radiation from personal electronic devices carried aboard aircraft." AIAA/IEEE ELECTRONIC DEVICES SYSTEMS CONFERENCE, 30. Oktober 1994 - 3. November 1994, Seiten 227-232, XP002073033 New York

## Beschreibung

Die Erfindung betrifft eine Anordnung zum Erkennen einer hochfrequenten Störstrahlung in der Passagierkabine eines Flugzeuges. Die bordeigenen elektronischen Systeme wie Funk- und Steuersysteme basieren zunehmend auf komplexen elektronischen Verfahren. Es ist daher erforderlich, Störstrahlungen, die möglicherweise die Funktion bordeigener Systeme beeinträchtigen könnten, rechtzeitig zu erkennen und zu vermeiden. Derartige Störstrahlungen gehen in erster Linie von tragbaren elektronischen Geräten aus, die von den Passagieren auch an Bord eines Flugzeuges benutzt werden. Hierzu zählen elektronische Spiele, CD-Spieler sowie tragbare Computer und Telefone.

Aus der GB 2 168 880 A ist eine Anordnung zur Durchführung von passagierbezogenen und/oder flugbegleiterbezogenen Informations-, Versorgungs-, überwachungs-, Unterhaltungs-, Interkommunikations- und Management-Funktionen in einem Flugzeug bekannt, wobei eine zentrale Prozessoreinheit vorgesehen ist. Die Prozessoreinheit, die eine Zentraleinheit, eine Eingabe/Ausgabe-Einheit sowie einen Programmspeicher und einen Arbeitsspeicher aufweisen kann, steht über ein Datenbussystem mit einer Vielzahl von örtlich verteilten, im Bereich der Passagiersitze angeordneten Datenterminals in Verbindung, die jeweils die passagier- bzw. flugbegleiterbezogenen Funktionen einleiten bzw. ausführen. Die Datenterminals sind an den Rückseiten der Rückenlehnen der Passagiersitze angeordnet und können jeweils eine Tastatur und einen Bildschirm besitzen. Diese bekannte Anordnung ist bedienungsfreundlich und platzsparend gestaltet, mit ihr können allerdings Störstrahlungen an Bord eines Flugzeuges nicht erfaßt werden.

In einem in der "AIAA/IEEE ELECTRONIC DEVICES SYSTEMS CONFERENCE, 30. Oktober 1994 - 3. November 1994, Seiten 227 - 232, XP002073033 New York erschienenen Aufsatz von Albert Helfrick wird das Problem beschrieben, daß durch tragbare elektronische Geräte an Bord eines Flugzeuges hochfrequente Strahlung erzeugt wird. Diese "Störstrahlungen" können den Flugzeug-Betrieb negativ beeinflussen.

Der Erfindung liegt nun die Aufgabe zugrunde, eine Anordnung der eingangs genannten Art derart auszubilden, daß damit die Frequenzbänder auf solche Störstrahlungen überwacht werden, die die einschlägigen Flugzeugsysteme beeinflussen, und daß die betreffenden Störstrahlungsquellen aufgrund der von der Anordnung empfangenen Störsignale lokalisierbar sind.

Die Aufgabe wird erfindungsgemäß gelöst durch eine Anordnung zum Erkennen einer hochfrequenten Störstrahlung in der Passagierkabine eines Flugzeuges,
- wobei in der Passagierkabine eine oder mehrere Empfangseinheiten und eine Überwachungseinheit angeordnet sind,
- wobei die Empfangseinheiten jeweils mindestens eine Antenne zur meßtechnischen Erfassung der Störstrahlungen aufweisen,
- wobei die überwachungseinheit mit einem Störungsrechner zur Auswertung der von der bzw. den Empfangseinheiten gelieferten Meßergebnisse versehen ist,
- wobei die Überwachungseinheit mit den Empfangseinheiten über eine Verbindung zur Übertragung digitaler Signale zusammenwirkt,
- wobei jedes von einer der Empfangseinheiten (3 bis 3n) abgegebene digitale Signal eine Kennung der Empfangseinheit, von der das Signal stammt, sowie Informationen über Frequenz und örtliche Feldstärke der aufgenommenen Störstrahlung enthält, und
- wobei der Störungsrechner mit mindestens einer Anzeigeeinheit verbunden ist.

Von besonderem Vorteil ist, daß Störstrahlungsquellen, die innerhalb eines sensiblen Frequenzbandes liegende Strahlung abgeben, vor, während und nach dem Flug sofort bei ihrer Inbetriebnahme feststellbar sind, so daß Maßnahmen zu ihrer Abschaltung ergriffen werden können und daß die wesentlichen Funktionen der Anordnung ohne zusätzliche Belastung des an Bord tätigen Personals ablaufen.

Vorteilhafte Weiterbildungen der Erfindung sind in den Unteransprüchen 2 bis 7 angegeben.

Die Erfindung ist anhand der Zeichnung dargestellt und nachfolgend näher erläutert. Es zeigen
- Fig. 1: einen Flugzeugrumpf mit einer Passagierkabine,
- Fig. 2: eine Teilansicht der Kabine nach Figur 1 im Grundriß,
- Fig. 3: die Kabine nach Figur 1 im Querschnitt,
- Fig. 4: ein Blockschaltbild der Anordnung mit einer zentralen Überwachungseinheit und mehreren Empfangseinheiten und
- Fig. 5: die interne Schaltung der Überwachungseinheit und der Empfangseinheit.

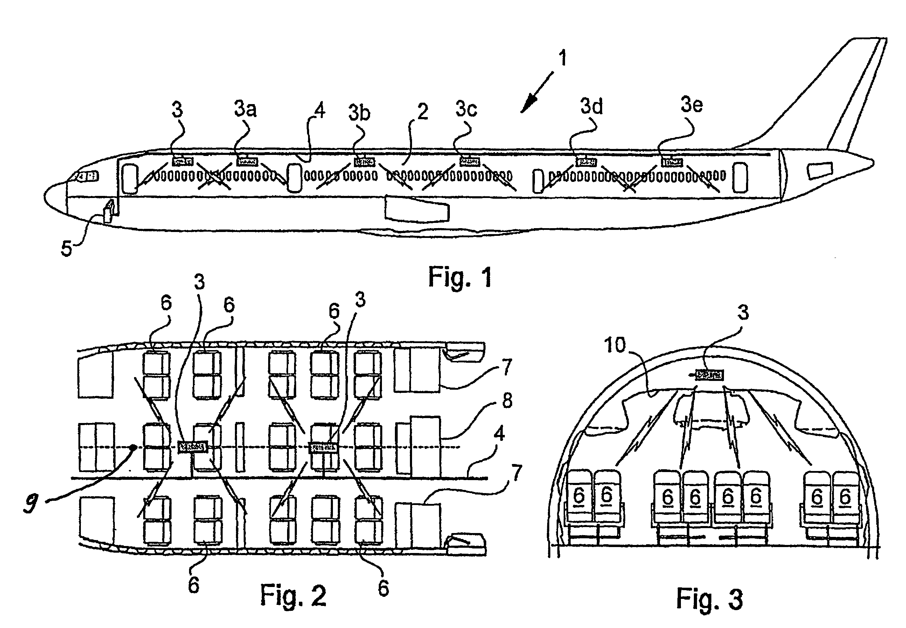

Figur 1 zeigt schematisch einen Flugzeugrumpf 1 mit einer Passagierkabine 2. Dabei sind im oberen Bereich der Kabine in deren Längsrichtung mehrere Empfangseinheiten 3 bis 3e verteilt angeordnet, die über eine durch einen Datenbus 4 realisierte Verbindung zur Übertragung digitaler Signale mit einer zentralen Überwachungseinheit 5 in Verbindung zusammenwirken. Figur 2 zeigt eine Teilansicht der Kabine nach Fig.1 im Grundriß mit Passagiersitzen 6 und weiteren Kabineneinbauten 7 und 8. Die Empfangseinheiten 3 sind senkrecht oberhalb der Rumpfachse 9 angeordnet. Jede der gezeigten Empfangseinheiten 3 bis 3e hat die Fähigkeit, mindestens die Frequenz und die Feldstärke einer Störstrahlung zu messen. Die Weiterleitung der jeweils ermittelten Meßwerte an die zentrale Überwachungseinheit 5 erfolgt über den Datenbus 4.

Figur 3 zeigt einen Querschnitt durch die Kabine 2 nach Figur 1 mit den Passagiersitzen 6 und einer Empfangseinheit 3. Ein Kabinenhimmel 10 bildet die obere Verkleidung der Kabine. Aus optischen Gründen sind die Empfangseinheiten 3 oberhalb des Himmels 10 angeordnet. Aufgrund des Materials, aus dem der Himmel besteht, nämlich aus Kunststoff, wird die Funktion der Empfangseinheiten durch den Himmel in keiner Weise beeinträchtigt.

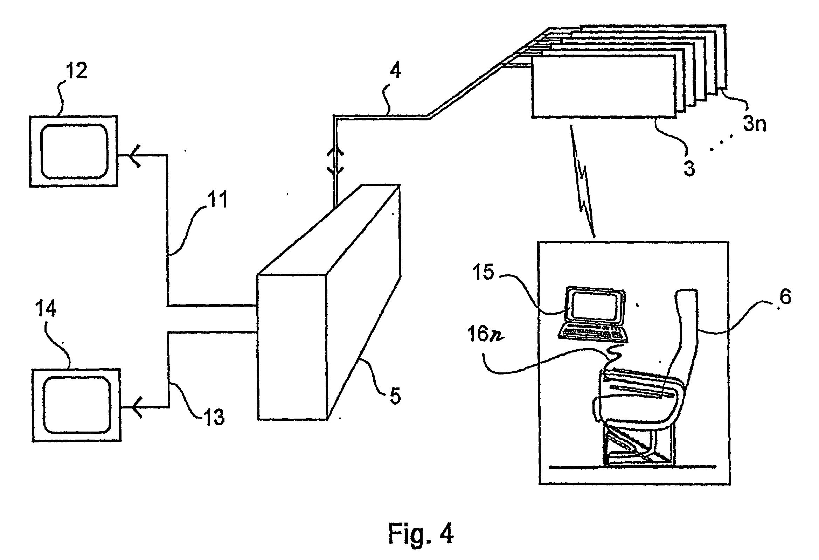

Figur 4 zeigt ein Blockschaltbild der Anordnung mit der zentralen Überwachungseinheit 5 und mehreren hieran über den Datenbus 4 angeschlossenen Empfangseinheiten 3 bis 3n. Weiterhin sind an die Überwachungseinheit 5 eine cockpitseitige Anzeigeeinheit 12 über eine Datenleitung 11 und eine kabinenseitige Anzeigeeinheit 14 über eine Datenleitung 13 angeschlossen. Innerhalb der Überwachungseinheit 5 ist ein Abbild der Sitzanordnung abgespeichert. Außerdem sind hier die Positionen der einzelnen Empfangseinheiten 3 bis 3n abgespeichert. Ein mit 6n bezeichneter Passagiersitz ist schematisch dargestellt, wobei eine den Sitz benutzende hier nicht gezeigte Person einen transportablen Rechner 15 benutzt, der über eine Zuleitung 16 aus dem elektrischen Bordnetz des Flugzeuges mit Energie versorgt wird. Die Empfangseinheiten 3 bis 3n können jede in einem sensiblen Frequenzbereich liegende Störstrahlung aufnehmen und leiten ein entsprechendes Signal an die Überwachungseinheit 5 weiter. Jedes derartige Signal enthält eine Kennung der Empfangseinheit, von der das Signal stammt sowie Informationen über Frequenz und örtliche Feldstärke der aufgenommenen Störstrahlung. Aus diesen Daten ermittelt die Überwachungseinheit 5 mit hinreichender Genauigkeit, wo sich das Zentrum eines Störstrahlungsfeldes befindet. So kann von der Überwachungseinheit 5 als Bereich, in dem sich die Störstrahlungsquelle befindet, beispielsweise die Reihe mit dem Sitz 6n ermittelt werden. Die Überwachungseinheit 5 leitet sodann ein entsprechendes Videosignal über die Datenleitungen 11 und 13 an die cockpitseitige Anzeigeeinheit 12 und die kabinenseitige Anzeigeeinheit 14 weiter. Hier ertönt ein akustisches Warnsignal, das anzeigt, daß eine Information über eine Störstrahlung abrufbereit in der Anzeigeeinheit vorliegt. Diese Information kann nun durch das Bordpersonal anhand einer Bedienungsmaßnahme, beispielsweise Betätigung eines Schalters, abgerufen werden. Daraufhin erscheint auf dem betreffenden Anzeigefeld ein Abbild der Sitzanordnung mit einer Einblendung der Sitzreihennumerierung, worin die Sitzreihe, in der sich der Sitz 6n befindet, deutlich markiert ist. Aufgrund der angezeigten Information kann der Benutzer des tranportablen. Rechners gezielt ermittelt und aufgefordert werden, sein Gerät abzuschalten.

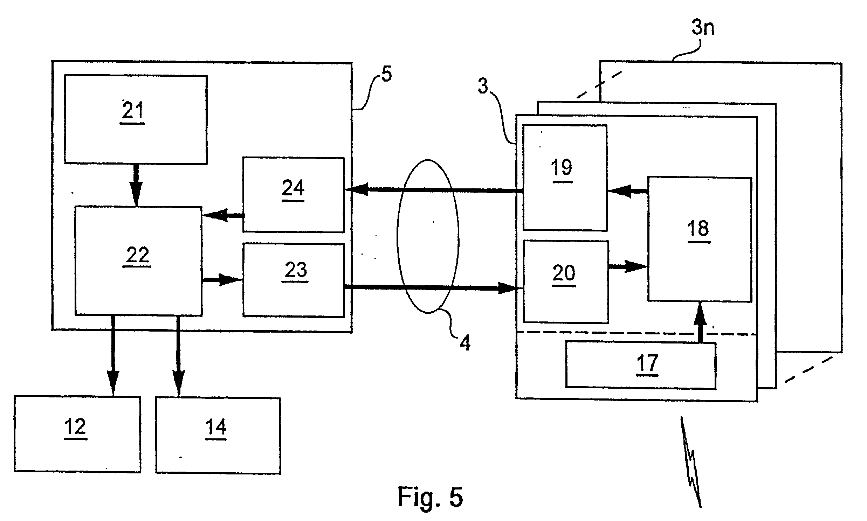

Figur 5 zeigt die innerhalb der Anordnung vorhandenen Daten- und Informationswege anhand der internen Funktionseinheiten der Empfangseinheiten 3 bis 3n und der Überwachungseinheit 5. Jede Empfangseinheit 3 bis 3n umfaßt eine Antenne 17, einen Frequenz-Scanner 18, einen Bus-Sender 19 und einen Bus-Empfänger 20. Je nach Gesamtbreite des zu überwachenden Frequenzbereiches sind gegebenenfalls mehrere auf die einzelnen Teilbereiche abgestimmte Antennen in einer Empfangseinheit 3 bis 3n vorgesehen. Das von der Antenne 17 aufgenommene Signal wird dem Frequenz-Scanner 18 zugeführt, der aufgrund einer entsprechenden Vorgabe prüft, ob die Feldstärke einer empfangenen Störstrahlung einen vorgegebenen Schwellenwert übersteigt und innerhalb eines sensiblen Frequenzbereiches liegt. Ist dies der Fall, so leitet der Frequenz-Scanner 18 ein entsprechendes Signal an den Bus-Sender 19 weiter, der seinerseits ein Signal über den Datenbus 4 an die Überwachungseinheit 5, absendet. Dieses Signal enthält eine Kennung der entsprechenden Empfangseinheit 3 bis 3n sowie Informationen über Frequenz und Feldstärke der Störstrahlung. Der ebenfalls an den Datenbus 4 angeschlossene Bus-Empfänger 20 empfängt von der Überwachungseinheit 5 ausgehende Befehle in Form von Vorgaben an den Frequenz-Scanner 18 bezüglich der besagten Schwellenwerte, der Auswahl von Frequenzbereichen sowie gegebenenfalls Anweisungen hinsichtlich der anzuwendenden Scan-Auflösung.

Die Überwachungseinheit 5 umfaßt eine Level-Matrix 21, einen Störungsrechner 22, eine Scan-Steuereinheit 23 und eine Scan-Eingabeeinheit 24. Die Level-Matrix 21 stellt praktisch eine Datenbank dar und enthält Daten über die den einzelnen Frequenzbereichen zugeordneten Schwellenwerte sowie über die Frequenzbänder, in denen die einzelnen Frequenzbereiche abzutasten sind. Außerdem sind hier Bedingungen abgespeichert, unter denen die besagten Schwellenwerte verändert werden können. So ist es beispielsweise denkbar, daß Schwellenwerte während des Starts und im Landeanflug relativ niedrig und im Reiseflug dann höher angesetzt werden. Die Scan-Eingabeeinheit 24 bereitet die von der Empfangseinheit 3 gelieferten Informationen auf und hält diese zur Eingabe in den Störungsrechner 22 bereit. Dieser vergleicht die Informationen mit den von der Level-Matrix 21 gelieferten und erstellt hieraus Ergebnissignale, die über die betreffenden Datenleitungen 11,13 an die cockpitseitige Anzeigeeinheit 12 und die kabinenseitige Anzeigeeinheit 14 weitergeleitet werden. Hier führen die Signale zu den in Verbindung mit Fig.4 beschriebenen Wirkungen.

Die Anordnung arbeitet vollautomatisch, so daß an Bord befindliche Störstrahlungsquellen ohne Zutun des Begleitpersonals festgestellt und lokalisiert werden. Die einzigen vom Bordpersonal auszuführenden Aktivitäten bestehen lediglich in der Beachtung und ordnungsgemäßen Umsetzung der der von der Anordnung gelieferten Warnsignale.

Die abgespeicherten Schwellenwerte stellen entsprechende Zulässigkeitsgrenzen dar. Hierdurch wird erreicht, daß unterhalb dieser Grenzen liegende Störstrahlungen, also unschädliche Strahlungen nicht berücksichtigt werden.

Eine Ausgestaltung der Erfindung besteht darin, daß der Datenbus 4 fester Bestandteil der Anordnung ist und zusammen mit dieser installiert wird.

Eine andere Ausgestaltung der Erfindung besteht darin, daß die Empfangseinheiten 3 und die Überwachungseinheit 5 so ausgebildet sind, daß sie mit einem bereits vorhandenen Datenbus, beispielsweise gemäß der Norm ARINC 429, problemlos zusammenwirken.

Gemäß einer weiteren Ausgestaltung der Erfindung ist vorgesehen, daß der Datenverkehr zwischen den Empfangseinheiten 3 bis 3n und der Überwachungseinheit 5 drahtlos per Funk abgewickelt wird. Hierzu sind die Empfangseinheiten 3 bis 3n und die Überwachungseinheit 5 mit entsprechenden Sender/Empfängern versehen. Diese Lösung bietet den Vorteil, daß bei der Installation der Anordnung eine Verlegung von Datenleitungen entfällt.

Eine weitere Ausgestaltung der Erfindung besteht darin, daß die Antenne 17 einer oder mehrerer der Empfangseinheit 3 bis 3n als mittels eines Antriebes um eine annähernd vertikale Achse drehrbare Peilantenne ausgebildet ist. Hierdurch kann durch eine Empfangseinheit 3 bis 3n nicht nur die Frequenz und die Feldstärke sondern auch die Einfallsrichtung einer Störstrahlung festgestellt werden. Obwohl diese Lösung einen höheren Aufwand mit sich bringt, ist hierbei jedoch von Vorteil, daß man mit weniger Empfangseinheiten 3 bis 3n auskommt und die Position einer Störstrahlungsquelle mit höherer Genauigkeit ermittelt wird.

## Patentansprüche

1. Anordnung zum Erkennen einer hochfrequenten Störstrahlung in der Passagierkabine (2) eines Flugzeuges,
- wobei in der Passagierkabine (2) eine oder mehrere Empfangseinheiten (3 bis 3n) und eine Uberwachungseinheit (5) angeordnet sind,
- wobei die Empfangseinheiten (3 bis 3n) jeweils mindestens eine Antenne (17) zur meßtechnischen Erfassung der Störstrahlung aufweisen,
- wobei die Überwachungseinheit (5) mit einem Störungsrechner (22) zur Auswertung der von der bzw. den Empfangseinheiten (3 bis 3n) gelieferten Meßergebnisse versehen ist,
- wobei die Überwachungseinheit (5) mit den Empfangseinheiten (3 bis 3n) über eine Verbindung zur Übertragung digitaler Signale zusammenwirkt,
- wobei jedes von einer der Empfangseinheiten (3 bis 3n) abgegebene digitale Signal eine Kennung der Empfangseinheit, von der das Signal stammt, sowie Informationen über Frequenz und örtliche Feldstärke der aufgenommenen Störstrahlung enthält, und
- wobei der Störungsrechner (22) mit mindestens einer Anzeigeeinheit (12, 14) verbunden ist.

2. Anordnung nach Anspruch 1, **dadurch gekennzeichnet, daß** jede der Empfangseinheiten (3 bis 3n) einen Frequenz-Scanner (18), einen Bus-Sender (19) und einen Bus-Empfänger (20) umfaßt.

3. Anordnung nach Anspruch 1 oder 2, **dadurch gekennzeichnet, daß** die Überwachungseinheit (5) zusätzlich zu dem Störungsrechner (22) eine Level-Matrix (21), die Daten über Frequenzbänder, Frequenzbereiche und letzteren zugeordnete Schwellenwerte enthält, eine Schwellenwertbefehle und Auswahlbefehle über Frequenzbereiche an die Empfangseinheiten (3 bis 3n) liefernde Scan-Steuereinheit (23) sowie eine Scan-Eingabeeinheit (24), die die von den Empfangseinheiten (3 bis 3n) gelieferten digitalen Signale aufbereitet, umfaßt.

4. Anordnung nach einem der Ansprüche 1 bis 3, **dadurch gekennzeichnet, daß** die Verbindung zur Übertragung digitaler Signale durch einen Datenbus (4) realisiert ist.

5. Anordnung nach Anspruch 4, **dadurch gekennzeichnet, daß** der Datenbus (4) fester Bestandteil der Anordnung und zusammen mit dieser installierbar ist.

6. Anordnung nach Anspruch 2 oder 3, **dadurch gekennzeichnet, daß** die Bus-Sender (19) und Bus-Empfänger (20) der Empfangseinheiten (3 bis 3n) als Sender bzw. Empfänger zur drahtlosen Übertragung digitaler Signale ausgebildet sind, und daß die Überwachungseinheit (5) einen Sender und Empfänger zur drahtlosen Übertragung digitaler Signale aufweist.

7. Anordnung nach Anspruch 1, **dadurch gekennzeichnet, daß** die Antennen (17) der Empfangseinheiten (3 bis 3n) als Peilantennen ausgebildet sind, die mittels eines Antriebes um eine annähernd vertikale Achse drehbar sind.

## Claims

1. Arrangement for detecting a high-frequency interference radiation in the passenger cabin (2) of an aeroplane,
- wherein one or more receiving units (3 to 3n) and a monitoring unit (5) are disposed in the passenger cabin (2),
- wherein the receiving units (3 to 3n) each have at least one aerial (17) for metrologically detecting the interfering radiation,
- wherein the monitoring unit (5) is provided with an interference computer (22) for evaluating the measurement results delivered by the receiving unit or units (3 to 3n),
- wherein the monitoring unit (5) interacts with the receiving units (3 to 3n) via a connection for transmitting digital signals,
- wherein each digital signal delivered by one of the receiving units (3 to 3n) contains an identifier of the receiving unit from which the signal originates and also items of information about frequency and local field strength of the recorded interfering radiation, and
- wherein the interference computer (22) is connected to at least one display unit (12, 14).

2. Arrangement according to Claim 1, **characterized in that** each of the receiving units (3 to 3n) comprises a frequency scanner (18), a bus transmitter (19) and a bus receiver (20).

3. Arrangement according to Claim 1 or 2, **characterized in that** the monitoring unit (5) comprises, in addition to the interference computer (22), a level matrix (21) that contains data about frequency bands, frequency ranges and threshold values assigned to the latter, a scan control unit (23) that delivers threshold-value instructions and selection instructions about frequency ranges to the receiving units (3 to 3n) and also a scan input unit (24) that processes the digital signals delivered by the receiving units (3 to 3n).

4. Arrangement according to one of Claims 1 to 3, **characterized in that** the connection for transmitting digital signals is implemented by a data bus (4).

5. Arrangement according to Claim 4, **characterized in that** the data bus (4) is a permanent component of the arrangement and can be installed together with it.

6. Arrangement according to Claim 2 or 3, **characterized in that** the bus transmitters (19) and bus receivers (20) of the receiving units (3 to 3n) are designed as transmitters or receivers, respectively, for the wireless transmission of digital signals and **in that** the monitoring unit (5) comprises a transmitter for the wireless transmission of digital signals.

7. Arrangement according to Claim 1, **characterized in that** the aerials (17) of the receiving units (3 to 3n) are designed as direction-finding aerials that can be rotated around an approximately vertical axis by means of a drive.

## Revendications

1. Dispositif pour détecter une radiation disturbatrice de haute fréquence dans la cabine de passagers (2) d'un avion, **caractérisé en ce que** :
- un ou plusieurs récepteurs (3 à 3n) et une unité de surveillance (5) sont disposés dans la cabine de passagers (2),
- les récepteurs (3 à 3n) présentent chacun une antenne (17) destinée à capter la radiation disturbatrice par des techniques de mesure,
- l'unité de surveillance (5) est équipée d'un ordinateur (22) destiné à évaluer les résultats des mesures effectuées par la ou les récepteurs (3 à 3n) ,
- l'unité de surveillance (5) est solidaire des récepteurs (3 à 3n), via une liaison de transmission de signaux numériques,
- chaque signal numérique émis par un des récepteurs (3 à 3n) porte un code d'identification du récepteur dont émane le signal, ainsi que des informations sur la fréquence et l'intensité du champ locale de la radiation disturbatrice captée, et
- l'ordinateur (22) est relié à au moins une unité d'affichage (12, 14).

2. Dispositif selon la revendication 1, **caractérisé en ce que** chaque récepteur (3 à 3n) contient un scanner de fréquences (18), un émetteur de bus de données (19) et un récepteur de bus de données (20).

3. Dispositif selon la revendication 1 ou 2, **caractérisé en ce que** l'unité de surveillance (5) comprend, en plus de l'ordinateur (22), une matrice à niveaux (21) avec des données sur les bandes de fréquence, les gammes de fréquences et les valeurs-seuils liées à ces dernières, une unité de commande et de scanning (23) donnant aux récepteurs (3 à 3n) des instructions pour les valeurs-seuils et la sélection, via des gammes de fréquences, ainsi qu'une unité d'entrée et de scanning (24) traitant les signaux numériques émis par les récepteurs (3 à 3n).

4. Dispositif selon une des revendications 1 à 3, **caractérisé en ce que** la liaison de transmission de signaux numériques est assurée par un bus de données (4) .

5. Dispositif selon la revendication 4, **caractérisé en ce que** le bus de données (4) est une composante fixe du dispositif et peut être installé en même temps que ce dernier.

6. Dispositif selon la revendication 2 ou 3, **caractérisé en ce que** l'émetteur de bus de données (19) et le récepteur de bus de données (20) des récepteurs (3 à 3n) sont conçus sous la forme d'émetteurs ou de récepteurs destinés à la transmission sans fil de signaux numériques, et **en ce que** l'unité de surveillance (5) présente un émetteur et un récepteur pour la transmission sans fil de signaux numériques.

7. Dispositif selon la revendication 1, **caractérisé en ce que** les antennes (17) des récepteurs (3 à 3n) se présentent sous la forme d'antennes radiogoniométriques pouvant pivoter autour d'un axe approximativement vertical à l'aide d'un mécanisme d'entraînement.
